# EUROPEAN PATENT APPLICATION

(11) **EP 2 357 725 A1**
(43) Date of publication of application: **17.08.2011**
(21) Application number: 10290077.6
(22) Date of filing: 17.02.2010
(51) Int. Cl.: H03F 1/02, H03F 3/60, H03F 3/72, H03F 3/21, H04B 1/04

(54) **Envelope tracking arrangement for improved backoff operation**

(71) Applicant: Alcatel Lucent, 75008 Paris (FR)
(72) Inventor: Wiegner, Dirk, 71409 Schwaikheim (DE); Luz, Gerhard, 74321 Bietigheim-Bissingen (DE)
(74) Representative: Kohler Schmid Möbus

(57) **Abstract**

The invention relates to an envelope tracking arrangement (1), comprising: at least two power transistors (5a, 5b) for amplification of an RF signal (2), and a modulator (8) for generating a modulated supply voltage M for the power transistors (5a, 5b), wherein the envelope tracking arrangement (1) is adapted to selectively provide the modulated supply voltage (V) to one or more of the power transistors (5a, 5b) based on a relation between a required output power and an overall maximum output power of the power transistors (5a, 5b). The invention also relates to a base station (16) and to a wireless communications network (18) comprising such an envelope tracking arrangement (1), as well as to a corresponding method.

## Description

### Field of the Invention

The invention relates to the field of telecommunications, and, more specifically, to efficiency improvements in the amplification of RF signals when using an envelope tracking concept.

### Background

This section introduces aspects that may be helpful in facilitating a better understanding of the invention. Accordingly, the statements of this section are to be read in this light and are not to be understood as admissions about what is in the prior art or what is not in the prior art.

When an RF signal is amplified in a power amplifier at part load operation, e.g. at 20% or 10% of the maximum load / maximum power (also referred to as backoff operation in the following), efficiency of the power amplifier is typically low. This may cause a problem especially when amplification of RF signals in base transceiver stations (BTS) of wireless communications networks is desired, as such a BTS is usually operated at full load only for a few (10 ― 20 %) hours a day.

Currently, Class-AB or Doherty based amplifiers are used in base transceiver stations, but these concepts show clearly reduced efficiency at high backoff / part load operation, e.g. at 10 % of the maximum peak / output power. Even though concepts such as Envelope Tracking promise efficiency improvement at low and mid backoff ranges, for high backoff (e.g. below 20 % of the full load) also a clearly reduced efficiency may occur. Concepts such as Class-S amplifiers or LINC also promise efficiency improvement at backoff operation, but these concepts still require intensive research and no reliable efficiency values for high backoff operation are available.

Thus, there is a need of operating power amplifiers in such a way that they may achieve high efficiency over a very wide backoff operation range. Additionally, it is very helpful if a power amplifier concept such as Envelope Tracking or Envelope Elimination and Restoration is used which supports multi-band and multi-standard operation in order to enable and support applications like Software Defined Radio or Cognitive Radio in a highly efficient manner.

### Summary

The present invention is directed to addressing the effects of one or more of the problems set forth above. The following presents a simplified summary of the invention in order to provide a basic understanding of some aspects of the invention. This summary is not an exhaustive overview of the invention. It is not intended to identify key or critical elements of the invention or to delineate the scope of the invention. Its sole purpose is to present some concepts in a simplified form as a prelude to the more detailed description that is discussed later.

A first aspect of the invention is implemented in an envelope tracking arrangement, comprising: at least two power transistors for amplification of an RF signal, and a modulator for generating a modulated supply voltage for the power transistors, wherein the envelope tracking arrangement is adapted to selectively provide the modulated supply voltage to one or more of the power transistors based on a relation of a desired output power to a maximum overall output power of the power transistors.

The invention relies on the multi-band and multi-standard capable Envelope Tracking (ET) concept. In principle, the ET concept may achieve high efficiency for low load operation. However, when driving a single power / RF transistor with the modulated supply voltage during low load operation, the single RF transistor would have to be operated only at very low modulated supply voltages, e.g. from 10 V or 15 V (almost) down to 0 V.

Consequently, during low power operation, i.e. when the currently provided / desired output power is e.g. only 10 % of the maximum output power, the problem arises that the RF transistor shows clearly degraded performance or is (nearly) switched-off, as it is driven with very low supply voltages.

In order to solve this problem, the present inventors propose to use an (envelope tracking, ET) modulator for providing a supply voltage to two or more power transistors. In such an arrangement, for high output power, which means full or mid load operation, e.g. down to 50 % of the maximum power which can be achieved by the arrangement, both power transistors may be active in a parallel configuration and may be operated as usual with the ET modulator based on the ET concept.

However, at low load operation, which would require very low modulated supply voltages when all power transistors are operated in parallel, it is proposed to reduce the number of power transistors used. Thus, depending on the backoff value, gradually all but one RF transistors may be switched-off and isolated from the ET modulator. It will be understood that the number of power transistors to which the supply voltage is provided depends on the required output power and is chosen such that the required output power can be attained.

For example, when only two power transistors are used, for high backoff values, one power transistor may be deactivated and only the other RF transistor may be operated by the ET modulator. Since this single power transistor has a clearly lower maximum peak power capability compared to the configuration when two or more RF transistors are active, a higher modulated supply voltage is required for reaching a required output power, such that the single power transistor doesn't need to be operated e.g. down to 0 V or 5 V supply voltage where it usually shows clearly degraded efficiency or is already tumed-off.

In one embodiment, the envelope tracking arrangement comprises at least one switch for selectively connecting or disconnecting at least one power transistor to/from the modulator. The switch is typically arranged in the supply line (Drain feed) from the modulator to the power transistor and may be switched on or off in dependence of the load situation e.g. by the modulator or another suitable control device of the ET arrangement.

In another embodiment, the power transistors are adapted for amplification with different maximum output power. It is possible to advantageously use the different maximum output power of the power transistors for defining suitable output power ranges. For instance, when using two power transistors, one with 100 W maximum output power and another one with 50 W maximum output power, it may be possible to use both power transistors during full to mid load operation, e.g. between 100 W and 150 W output power. For a power range between 50 W to 100 W, the supply voltage may only be provided to the power transistor having higher maximum output power. For very low load operation, e.g. between 0 W to 50 W, only the power transistor with the higher maximum output power is switched off. Thus, the power transistor having smaller maximum power will still be driven by the modulated supply voltage, and for attaining the desired output power, this power transistor need to be driven with a higher supply voltage, such that its efficiency increases. It will be understood that alternatively, all power transistors may have identical maximum output power, although this will in general be less useful for very low load operation.

Typically, the envelope tracking arrangement has a single RF input line. For providing the RF signal to the (parallel) power transistors, the RF input line is split into parallel RF paths at a splitting point. In a similar way, the envelope tracking arrangement typically also comprises a combining point for combining parallel RF paths from the power transistors, such that the amplified RF signal may be output on a common RF output line.

In one embodiment, the envelope tracking arrangement comprises at least one switchable blocking unit for selectively blocking the RF path to/from a power transistor which is (currently) not provided with the modulated supply voltage. Even though the power transistor(s) of unused RF paths are switched off, part of the power of the RF signal may still be provided from the splitting / combining point to the unused RF path. This may be avoided by the switchable blocking units which are typically arranged at the splitting point for blocking the RF input signal and at the combining point for blocking the RF output signal, respectively. In some embodiments, at least some of the switchable blocking units are implemented as RF switches which provide physical blocking of the RF path. In this case, the switches may be implemented in the form of Micro-Electro-Mechanical switches (MEMS).

Alternatively, the switchable blocking unit may be adapted for blocking a center frequency of the RF signal. In other words, the blocking unit does not provide a physical blocking of the RF path, but blocks the RF path only for a pre-defined frequency range. For this purpose, the RF blocking unit may comprise a wave line section having a width and length which are selected such that a desired frequency can be blocked, provided that the blocking unit is switched on, i.e. that the wave line section is connected to the combining or splitting point, respectively. It will be understood that alternatively or in addition, other components such as capacitors, inductors, etc. may be used for blocking a desired RF frequency. One skilled in the art will appreciate that depending on the type of RF signal to be amplified, a plurality of blocking units for blocking a plurality of different frequencies may be provided.

In one embodiment, the envelope tracking arrangement comprises at least one of an input impedance matching network for impedance matching between the RF input line and an input to the power transistors and an output impedance matching network for impedance matching between an output of the power transistors and the RF output line. Typically, the impedance is matched in such a way that a desired input and output impedance, e.g. 50 Ohm, are provided at the RF input line and the RF output line, respectively. It will be understood that the design of the impedance matching network should be chosen such that the desired impedance can be attained irrespective of the operation mode, i.e. when all RF paths are used and also when one or more RF paths are blocked.

A further aspect relates to a base station comprising at least one envelope tracking arrangement of the kind described above. The envelope tracking arrangement is used for amplifying an RF signal which is subsequently provided to a transmitter antenna for wireless transmissions. The power required for the transmission is dependent on the load situation of the base station which is usually operated at full load only for a few (10 ― 20 %) hours a day. Thus, most of the time, only a small part of the maximum transmission power is required, such that using an envelope modulator arrangement which has improved efficiency for low load situations is especially advantageous.

In one embodiment, the base station further comprises a digital frontend unit for generating an envelope signal of the RF signal to be provided as an input to the modulator. The digital frontend unit may e.g. generate a baseband signal with is provided to the envelope tracking arrangement after digital-to-analogue and up-conversion. The digital frontend unit may also generate an envelope signal which is provided as an input to the modulator, the envelope signal being synchronized with the generation of the RF signal.

A further aspect relates to a wireless communication network comprising at least one base station of the kind described above. Due to the envelope tracking arrangement, the base station and thus the overall network shows a higher efficiency when being operated with low load, leading to a reduction of the operation expenses of the network, respectively, of the base station.

A further aspect relates to a method for power amplification of an RF signal, comprising: Generating a modulated supply voltage for at least two power transistors; and amplifying the RF signal in the power transistors by selectively providing the modulated supply voltage to one or more of the power transistors in dependence of a relation of a desired output power to an overall maximum output power of the power transistors. The maximum overall output power of the power transistors is defined herein as the sum of the maximum output power of the individual power transistors in a parallel configuration, whether or not these are switched on or off.

For example, when a first power transistor has a maximum power of 100 W and a second power transistor has a maximum power of 50 W, the maximum output power is 150 W and defines the full load of the arrangement. The switching-off of at least one power transistor may be performed when the desired / required output power is smaller than a pre-defined fraction, e.g. 50 % or 20 % of the maximum overall output power (full load). In particular, in this configuration, three output power ranges may be defined depending on the load: a first one in which both power transistors are kept active (e.g. from 100 W to 150 W), a second one in which only the power transistor with 100 W maximum output power is kept active (e.g. from 50 W to 100 W), and a third one in which only the power transistor with 50 W output power is kept active (e.g. from 0 W to 50 W). It will be understood that the thresholds which limit the ranges do not necessarily correspond to the maximum output power of the individual power transistors, but may vary based on the overall efficiency of the configuration. For instance, the second range may be between 40 W and 100 W, and the third range may be between 0 W and 40 W.

In one variant, the power transistors are adapted for amplification with different maximum output power. As indicated above, in this case, the modulated supply voltage may be selectively provided to only one power transistor. For this purpose, that one of the power transistors is selected which has the smallest maximum output power which is still above the required output power. A modulated supply voltage provided to the single active power transistor has to be increased for reaching the desired output power as compared to a situation where two or more power transistors are operated in parallel. Thus, the single power transistor can be operated with high efficiency.

In another variant, the method comprises blocking an RF path of at least one power transistor which is not provided with the modulated supply voltage. By blocking the RF path of the unused power transistor, the RF signal passes only through those of the RF paths having active power transistors.

A final aspect of the invention relates to a computer program product comprising code means adapted for performing all the steps of the method described above.

Further features and advantages are stated in the following description of exemplary embodiments, with reference to the figures of the drawing, which shows significant details, and are defined by the claims. The individual features can be implemented individually by themselves, or several of them can be implemented in any desired combination.

### Brief Description of the Figures

Exemplary embodiments are shown in the diagrammatic drawing and are explained in the description below. The following are shown:
- **Fig. 1**: shows a schematic diagram of an embodiment of an envelope tracking arrangement with two parallel power transistors, and
- **Fig. 2**: shows a schematic diagram of the efficiency of a power transistor, respectively, of the envelope tracking arrangement of Fig. 1 in dependence of a load condition.

### Description of the Embodiments

The functions of the various elements shown in the Figures, including any functional blocks labeled as 'processors', may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term 'processor' or 'controller' should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

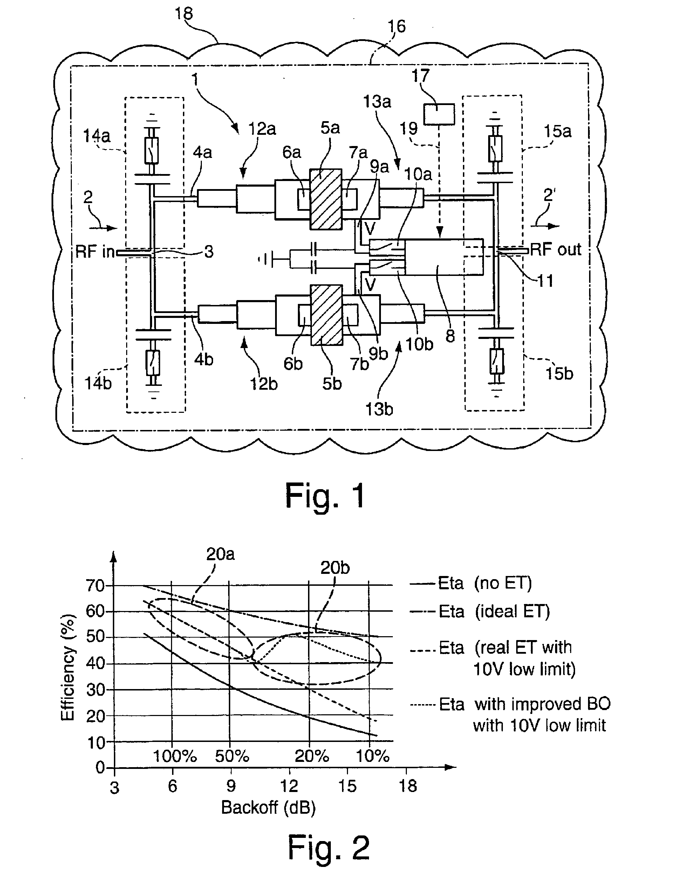

**Fig. 1** shows an exemplarily embodiment of an envelope tracking arrangement **1** for amplification of an RF signal **2** which is provided to an input line "**RF in**" of the arrangement 1. The RF signal 2 is split at a splitting point **3** and is fed to two parallel RF paths **4a, 4b,** each comprising a power transistor **5a, 5b.** The power transistors 5a, 5b each have an input terminal **6a, 6b** and an output terminal **7a, 7b** for the RF signal 2 and the amplified RF signal **2'**, respectively. The first power transistor 5a has a maximum (peak) output power of 100 W, the second power transistor 5b has a maximum output power of 50 W.

In the present example, the power transistors 5a, 5b are implemented as field effect transistors with a grounded source terminal (not shown). Alternatively, the power transistors 5a, 5b may be implemented as bipolar transistors. When using a field effect transistor, transistor elements based on metal oxide semiconductor (MOS) technology or High Electron Mobility transistors (HEMT) using, for instance, gallium nitride (GaN) as a semiconductor material may be used. Alternatively, the power transistors may e.g. be implemented as high-voltage hetero-junction bipolar transistors (HVHBT) using e.g. gallium arsenide (GaAs) as a semiconductor material.

The two power transistors 5a, 5b of the present example have different peak / maximum power class, the first power transistor 5a having 100 W peak power, the second power transistor 5b having 50 W peak power. One skilled in the art will appreciate that RF transistors having other values of the maximum power are also possible. In particular, it is also possible that both transistors 5a, 5b have the same power class / maximum power. Moreover, although the transistor (chips) 5a, 5b of Fig. 1 are unpackaged, it will be understood that it is also possible to use packaged transistors, e.g. in a so-called Push-Pull Package, having two or more chips, wherein different terminals are used for contacting the chips arranged in the package.

Both RF transistors 5a, 5b are supplied at their output terminal 7a, 7b (Drain) with a modulated / adaptive supply voltage **V** provided by one and the same ET modulator **8** via a suitable Drain feed line **9a, 9b,** each comprising a switch **10a, 10b**. Due to the switches 10a, 10b integrated in the feed lines 9a, 9b, a respective one of the RF transistors 5a, 5b may be isolated from the ET modulator 8 and may thus be turned off. The switching off may occur e.g. for high backoff operation, as will be described in more detail below. It will be understood that it may also be possible to provide the adaptive supply voltage V using different ET modulators.

The output terminals 7a, 7b of the RF / power transistors 5a, 5b are connected via the RF paths 4a, 4b to a combining point **11**, leading to a common RF output line "**RF out**" for the amplified RF signal 2'. The envelope tracking arrangement 1 also comprises an input impedance matching network **12a, 12b** and an output impedance matching network **13a, 13b** for impedance matching between the input terminals 6a, 6b and the RF input line "RF in" and between the output terminals 7a, 7b and the RF output line "RF out", respectively.

Also, in the present example, the impedance matching networks 12a, 12b, 13a, 13b are implemented as a plurality of wave line sections arranged in the RF paths 4a, 4b having a width and length which is chosen such that the desired input / output impedance at the RF input line "RF in" and the RF output line "RF out" can be attained, which may be for instance 50 Ohm. As the power transistors 5a, 5b may be selectively switched on or off depending on the load situation, the input and output matching networks 12a, 12b, 13a, 13b have to provide the required impedances for the case that both power transistors 5a, 5b are active as well as for the case that only one of the power transistors 5a, 5b is in an active operation mode.

For avoiding that the RF signal 2, 2' may enter into an RF path 4a, 4b having a power transistor 5a, 5b which is currently switched off, i.e. disconnected from the ET modulator 8, switchable RF blocking units **14a, 14b, 15a, 15b** are provided both at the splitting point 3 and at the combining point 11, respectively. The blocking units 14a, 14b, 15a, 15b each comprise a capacitor and a wave line section which are chosen such that a respective unused RF path 4a, 4b may be blocked for an RF signal 2, 2' of a given (pre-defined) center frequency. Each blocking unit 14a, 14b, 15a, 15b also comprises a switch (e.g. a PIN diode), which allows grounding of the wave line section in order to provide an RF open / short for the specific (center) frequency at the splitting point 3 or the combining point 11 of the RF paths 4a, 4b, respectively.

It will be understood that the specific configuration of the RF blocking units 14a, 14b 15a, 15b as described herein constitutes only one example for implementing RF blocks and that other ways of RF blocking which are known in the art may be used as well. In particular, blocking units in the form of switches, e.g. implemented in MEMS technology, may be used which physically block the RF paths 4a, 4b (for all frequencies).

The envelope tracking arrangement 1 is part of a base station **16** which is itself part of a wireless communication network **18**. The base station 16 also comprises a digital frontend unit **17**, the latter generating an envelope signal **19** of the RF signal 2 which is amplified in the ET arrangement 1, the envelope signal 19 being provided as an input to the ET modulator 8. The ET modulator 8 uses the envelope signal for generating the adaptive supply voltage V which is provided to the power transistors 5a, 5b. Depending on the load situation of the base station 16, the required output power of the amplified RF signal 2' may vary, which causes a variation of the modulated adaptive supply voltage V. Typically, the supply voltage V decreases when the required output power deceases.

The backoff may be defined as a fraction of the currently required / produced output power to the maximum output power which can be generated by the power transistors 5a, 5b of the envelope tracking arrangement 1, being 100 W + 50 W = 150 W in the present example. When both power transistors 5a, 5b are operated in parallel with a high backoff, e.g. 20 % or less, the supply voltage V will be low as well, e.g. close to 0 V, leading to a degradation in the efficiency of both power transistors 5a, 5b.

In the present example, for providing high efficiency also for high backoff situations, the first power transistor 5a with the higher maximum/peak power will be switched off. In this way, the modulated supply voltage V for the second power amplifier 5b has to be increased in order to reach the desired (low) output power of the RF output signal 2', thus increasing efficiency of the amplification of the second power transistor 5b. As the first power transistor 5a is switched off as well, the overall efficiency of the envelope tracking arrangement may be improved considerably.

The efficiency improvement will now be illustrated with reference to **Fig. 2** which shows efficiency curves in dependence of backoff (represented both in % and in dB) for different load situations. A first curve (full line) shows the simulated efficiency characteristic of an ideal Class-B amplifier (without ET), as well as a ideal (i.e. no modulator losses and down to 0 V supply voltage as well as Class-B operation) ET characteristic (dash-dotted line), and a more real (including modulator losses and down to only 10 V supply voltage as well as Class-B operation) ET characteristic (dashed line), for a basic qualitative illustration and comparison of the efficiency in dependence of backoff.

As can be gathered from Fig. 2, the (realistic) efficiency curve (dashed line) may be improved by making use of the above-described idea, leading to a (dotted) efficiency curve for high backoff values (about -10 dB or less than about 40 %):
Thus, in a first operation mode **20a** (represented on the left-hand side of Fig. 2), i.e. at low and mid backoff (100% to approx. 40%), both power transistors 5a, 5b are active and operated in ET mode, whereas in a second operation mode **20b** at high backoff (below approx. 40 %) only the second transistor 5b (having in the present example only half the power capability of the first transistor 5a) is active and operated in ET mode, leading to an improvement in efficiency. It should be noted that the dotted efficiency curve is based on simulation data for a single device ET operation and thus is only intended to provide a basic qualitative overview.

Those skilled in the art will appreciate that the backoff value which is used as a threshold for switching between the first operation mode 20a and the second operation mode 20b may vary depending on the application and may be chosen to be lower or higher than in the present example. Also, in the configuration represented in Fig. 1, it will be possible to use a third operation mode in which only the first power transistor 5a is active. In this case, three output power ranges may be defined depending on the load: a first one in which both power transistors 5a, 5b are kept active (e.g. from 100 W to 150 W, low backoff (66,6 % to 100 %)), a second one in which only the first power transistor 5a with 100 W maximum output power is kept active (e.g. from 50 W to 100 W, mid backoff (33,3 % to 66,6%)), and a third one in which only the power transistor with 50 W output power is kept active (e.g. from 0 W to 50 W, high backoff (0 % to 33,3%)).

One skilled in the art will also readily appreciate that, if appropriate, more than two power transistors may be arranged in corresponding parallel RF paths, the power transistors being switched on or off selectively at specific, pre-defined backoff values. For instance, when three power transistors are provided, all of them may be active for high backoff values, one of them being switched off for medium backoff values, and two of them being switched off for low backoff values.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Also, the description and drawings merely illustrate the principles of the invention. It will thus be appreciated that those skilled in the art will be able to devise various arrangements that, although not explicitly described or shown herein, embody the principles of the invention and are included within its scope.

Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. Envelope tracking arrangement (1), comprising:
at least two power transistors (5a, 5b) for amplification of an RF signal (2), and
a modulator (8) for generating a modulated supply voltage (V) for the power transistors (5a, 5b), wherein the envelope tracking arrangement (1) is adapted to selectively provide the modulated supply voltage (V) to one or more of the power transistors (5a, 5b) based on a relation between a required output power and an overall maximum output power of the power transistors (5a, 5b).

2. Envelope tracking arrangement according to claim 1, comprising at least one switch (10a, 10b) for selectively connecting or disconnecting at least one power transistor (5a, 5b) to/from the modulator (8).

3. Envelope tracking arrangement according to claim 1 or 2, wherein the power transistors (5a, 5b) are adapted for amplification with different maximum output power.

4. Envelope tracking arrangement according to any one of the preceding claims, further comprising a splitting point (3) for splitting an RF input line (RF in) into parallel RF paths (4a, 4b) to the power transistors (5a, 5b).

5. Envelope tracking arrangement according to any one of the preceding claims, further comprising a combining point (11) for combining parallel RF paths (4a, 4b) from the power transistors (5a, 5b) to a common RF output line (RF out).

6. Envelope tracking arrangement according to claim 4 or 5, further comprising at least one switchable blocking unit (14a, 14b, 15a, 15b) for blocking an RF path (4a) to/from a power transistor (5a) which is not provided with the modulated supply voltage (V).

7. Envelope tracking arrangement according to claim 6, wherein the switchable blocking unit (14a, 14b, 15a, 15b) is adapted for blocking a center frequency of the RF signal (2, 2').

8. Envelope tracking arrangement according to any one of claims 4 to 7, further comprising: at least one of an input impedance matching network (12a, 12b) for impedance matching between the RF input line (RF in) and an input (6a, 6b) to the power transistors (5a, 5b) and an output impedance matching network (13a, 13b) for impedance matching between an output (7a, 7b) of the power transistors (5a, 5b) and the RF output line (RF out).

9. Base station (16) comprising at least one envelope tracking arrangement (1) according to any one of the preceding claims.

10. Base station according to claim 9, further comprising a digital frontend unit (17) for generating an envelope signal (19) of the RF signal (2) to be provided as an input to the modulator (8).

11. Wireless communications network (18), comprising at least one base station (16) according to claim 9 or 10.

12. Method for amplification of an RF signal (2), comprising:
generating a modulated supply voltage (V) for at least two power transistors (5a, 5b), and
amplifying the RF signal (2) in the power transistors (5a, 5b) by selectively providing the modulated supply voltage (V) to one or more of the power transistors (5a, 5b) based on a relation between a required output power and an overall maximum output power of the power transistors (5a, 5b).

13. Method according to claim 12, wherein the power transistors (5a, 5b) are adapted for amplification with different maximum output power.

14. Method according to claim 12 or 13, further comprising: blocking an RF path (4a, 4b) of at least one power transistor (5a, 5b) which is currently not provided with the modulated supply voltage (V).

15. Computer program product comprising code means adapted for performing all the steps of the method according to any one of claims 12 to 14.

## Amended claims

### Amended claims in accordance with Rule 137(2) EPC.

**1.** Envelope tracking arrangement (1), comprising:
at least two power transistors (5a, 5b) for amplification of an RF signal (2),
a modulator (8) for generating a modulated supply voltage (V) for the power transistors (5a, 5b), and
a splitting point (3) for splitting an RF input line (RF in) into parallel RF paths (4a, 4b) to the power transistors (5a, 5b),
**characterized in that**
the envelope tracking arrangement (1) is adapted to selectively provide the modulated supply voltage (V) to one or to more than one of the power transistors (5a, 5b), the number of power transistors (5a, 5b) to which the modulated supply voltage (V) is provided being dependent on a relation between a required output power and an overall maximum output power of the power transistors (5a, 5b), and **in that** the envelope tracking arrangement (1) further comprises at least one switchable blocking unit (14a, 14b, 15a, 15b) for blocking an RF path (4a) to a power transistor (5a) which is not provided with the modulated supply voltage (V).

**2.** Envelope tracking arrangement according to claim 1, comprising at least one switch (10a, 10b) for selectively connecting or disconnecting at least one power transistor (5a, 5b) to/from the modulator (8).

**3.** Envelope tracking arrangement according to claim 1 or 2, wherein the power transistors (5a, 5b) are adapted for amplification with different maximum output power.

**4.** Envelope tracking arrangement according to any one of the preceding claims, further comprising a combining point (11) for combining parallel RF paths (4a, 4b) from the power transistors (5a, 5b) to a common RF output line (RF out).

**5.** Envelope tracking arrangement according to claim 1, wherein the switchable blocking unit (14a, 14b, 15a, 15b) is adapted for blocking a center frequency of the RF signal (2, 2').

**6.** Envelope tracking arrangement according to claim 4, further comprising:
at least one of an input impedance matching network (12a, 12b) for impedance matching between the RF input line (RF in) and an input (6a, 6b) to the power transistors (5a, 5b) and an output impedance matching network (13a, 13b) for impedance matching between an output (7a, 7b) of the power transistors (5a, 5b) and the RF output line (RF out).

**7.** Base station (16) comprising at least one envelope tracking arrangement (1) according to any one of the preceding claims.

**8.** Base station according to claim 7, further comprising a digital frontend unit (17) for generating an envelope signal (19) of the RF signal (2) to be provided as an input to the modulator (8).

**9.** Wireless communications network (18), comprising at least one base station (16) according to claim 7 or 8.

**10.** Method for amplification of an RF signal (2), comprising:
generating a modulated supply voltage (V) for at least two power transistors (5a, 5b) being arranged in parallel RF paths (4a, 4b) branching off from a splitting point (3) of an RF input line (RF in), and amplifying the RF signal (2) in the power transistors (5a, 5b),
**characterized by**
selectively providing the modulated supply voltage (V) to one or to more than one of the power transistors (5a, 5b), the number of power transistors (5a, 5b) to which the modulated supply voltage (V) is provided being dependent on a relation between a required output power and an overall maximum output power of the power transistors (5a, 5b), and
blocking an RF path (4a, 4b) of at least one power transistor (5a, 5b) which is currently not provided with the modulated supply voltage (V).

**11.** Method according to claim 10, wherein the power transistors (5a, 5b) are adapted for amplification with different maximum output power.

**12.** Computer program product comprising code means adapted for performing all the steps of the method according to any one of claims 10 or 11.
